# FASCICULE DE BREVET EUROPEEN

(11) **EP 1 075 780 B1**
(45) Date de publication et mention de la délivrance du brevet: **20.02.2002**
(21) Numéro de dépôt: 99915804.1
(22) Date de dépôt: 20.04.1999
(51) Int. Cl.: H05K 7/14

(54) **STRUCTURE MODULAIRE SIMPLIFIEE**
VEREINFACHTE MODULARE STRUKTUR
SIMPLIFIED MODULAR STRUCTURE

(30) Priorité: 28.04.1998 FR 9805323
(43) Date de publication de la demande: 14.02.2001
(73) Titulaire: THALES AVIONICS S.A., 78141 Vélizy Villacoublay Cédex (FR)
(72) Inventeur: SARNO, C., Thomson-CSF Propriété Int. Brevets, 94117 Arcueil Cedex (FR); BOUTEILLE, H., Thomson-CSF Propriété Int. Brevets, 94117 Arc ueil Cedex (FR)
(74) Mandataire: Guérin, Michel
(86) Numéro de dépôt international: FR9900935
(87) Numéro de publication internationale: WO9956514

(56) Documents cités:
- EP-A- 0 578 520
- US-A- 4 533 978
- US-A- 4 652 969
- US-A- 4 771 365
- US-A- 5 506 373

## Description

La présente invention concerne une structure modulaire destinée à accueillir une ou plusieurs cartes de circuit imprimé et devant être connectée à une installation électronique.

Une telle structure est connue par exemple du EP-A-0 578 520 qui révèle une structure modulaire porte-carte de circuit imprimé, apte à venir s'engager, à la façon d'un tiroir, dans une baie d'une installation électronique. Cette structure modulaire comprend au moins un cadre dans lequel une carte de circuit imprimé est logée. Le cadre comporte aussi des échancrures destinées à recevoir des groupes de connexion et deux flancs latéraux munis de moyen de fixation, sur chacun desquels peuvent venir se fixer soit une plaque de fermeture soit un deuxième cadre identique au premier. Le montant postérieur du cadre est destiné à recevoir l'axe de pivotement d'un dispositif de verrouillage.

La présente invention s'applique notamment mais pas exclusivement aux installations électroniques de type avionique modulaire intégrée, situées à bord d'aéronefs où elles sont susceptibles d'être soumises à des conditions d'environnement sévères telles que des vibrations, des accélérations brusques, des chocs, de l'humidité etc...

Une structure modulaire classique comprend au moins un cadre qui délimite un volume dans lequel peut prendre place une carte de circuit imprimé, ce cadre comportant deux flancs latéraux munis de moyens de fixation, chacun peut venir se fixer soit à une plaque de fermeture, soit à un autre cadre.

Ce cadre, généralement moulé ou usiné, est difficile à réaliser avec de bonnes tolérances. Sa fabrication est coûteuse. Il comporte un certain nombre de moulures, d'échancrures, de gorges à la fois à l'intérieur et à l'extérieur de ses montants et traverses. Une telle structure modulaire avec cadre est relativement lourde, coûteuse et n'apporte pas toute satisfaction au point de vue thermique, les calories dégagées par les composants électroniques de la carte de circuit" imprimé devant être évacuées efficacement pour un fonctionnement optimum. De plus, son poids constitue un handicap du point de vue de la masse embarquée. Il n'est pas rare que lors d'opérations de maintenance sur un aéronef, son échange doive se faire en quelques secondes seulement et il doit pouvoir être manipulé aisément.

La présente invention a donc plus particulièrement comme but de supprimer ces inconvénients notamment de poids, de prix et de refroidissement.

Pour cela, elle propose une structure modulaire apte à recevoir une ou plusieurs cartes de circuit imprimé ne possédant pas de cadre.

Une telle structure modulaire est particulièrement simple à réaliser et à monter. Elle maintient efficacement les cartes de circuits imprimés qu'elle loge tout en restant légère et aisément manipulable.

Plus précisément la présente invention est relative à une structure modulaire porte-carte de circuit imprimé, apte à être connectée à une installation électronique, comportant deux capots placés en vis-à-vis, contribuant à délimiter un logement pour au moins une carte de circuit imprimé.

Les capots coopèrent l'un avec l'autre en prenant en sandwich, au niveau d'un premier bord des moyens de support d'un ou plusieurs blocs de connexion et au niveau d'un deuxième bord des moyens de support d'un mécanisme de verrouillage pour maintenir la structure dans une position connectée, les moyens de support des blocs de connexion et du mécanisme de verrouillage ayant des extrémités disjointes avant montage.

De préférence, les capots intègrent sur au moins un autre bord des moyens de rigidification permettant entre autre d'améliorer la coopération des capots entre eux.

Les moyens de support du mécanisme de verrouillage peuvent prendre la forme d'au moins un barreau.

Les moyens de support des blocs de connexion peuvent prendre la forme d'au moins un barreau agencé de manière à contribuer à délimiter, lorsqu'il est pris en sandwich entre les deux capots, une ou plusieurs alvéoles ouvertes vers l'extérieur du logement, destinées à recevoir les blocs de connexion Un bloc de connexion dans une alvéole est destiné à être relié d'une part à la carte de circuit imprimé et d'autre part à un autre bloc de connexion, extérieur à la structure et se présentant face à lui.

Les moyens de rigidification peuvent être matérialisés par au moins une portion réalisant au moins un changement de direction par rapport à la surface principale du capot. Un mode de réalisation préféré est d'utiliser comme moyens de rigidification une cornière à deux ailes, l'une médiane et l'autre extrême, ces ailes réalisant deux changements de direction par rapport à la surface principale du capot.

Les ailes extrêmes peuvent être pourvues de perçages en vue de leur assemblage.

Pour réaliser une bonne ventilation interne du logement, les ailes médianes peuvent être pourvues d'au moins une ouverture de ventilation.

Pour pouvoir loger des composants électroniques volumineux sans augmenter de manière significative l'encombrement de la structure modulaire, l'aile médiane d'une cornière appartenant à l'un des capots peut avoir une largeur différente de celle d'une cornière appartenant à l'autre capot.

Pour améliorer le maintien et le raidissement de la carte de circuit imprimé, il est possible de prévoir qu'elle porte au moins une barre de raidissement. Les résultats sont améliorés si la barre de raidissement est solidaire d'un des capots. Il est aussi possible de prévoir que la carte de circuit imprimé porte au moins une barre de raidissement sur chacune de ses faces.

Dans une structure modulaire à une seule carte de circuit imprimé, les deux barres de raidissement peuvent être solidaires chacune d'un des capots.

Dans une configuration avec deux barres de raidissement portées par deux faces différentes de la carte de circuit imprimé, il n'est pas nécessaire que ces barres aient la même longueur.

Par contre, il est préférable qu'elles aient sensiblement la même orientation.

Dans les structures modulaires à plusieurs cartes de circuit imprimé, les capots prennent en sandwich au moins un espaceur, au niveau des moyens de rigidification.

Pour favoriser une bonne ventilation interne, il est préférable que l'espaceur soit pourvu d'au moins une ouverture de ventilation.

Une des cartes de circuit imprimé est fixée à un espaceur lorsque la structure modulaire loge plus de deux cartes de circuit imprimé.

Pour garantir une sécurité satisfaisante lors de l'introduction de la structure modulaire dans une baie, il est possible d'intégrer des moyens de détrompage au niveau des moyens de support des blocs de connexion.

De la même manière, pour faciliter le positionnement de la structure dans la baie, il possible d'intégrer des moyens de positionnement sur les moyens de support des blocs de connexion.

D'autres caractéristiques et avantages de l'invention apparaîtront à la lecture de la description suivante faite, à titre d'exemples non limitatifs, en liaison avec les figures annexées qui représentent :

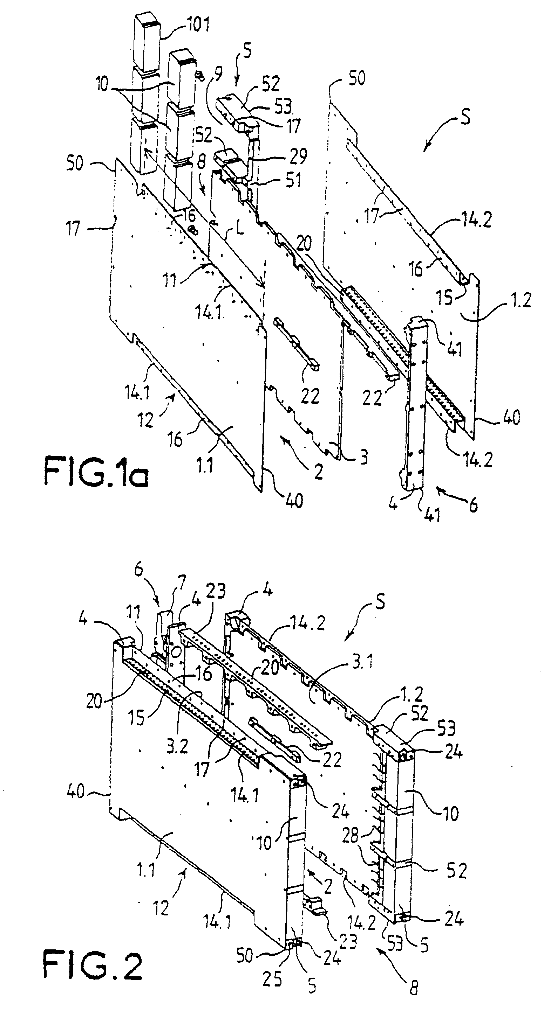

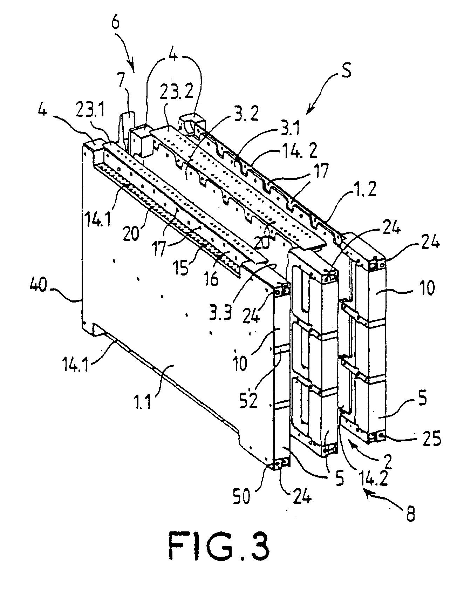

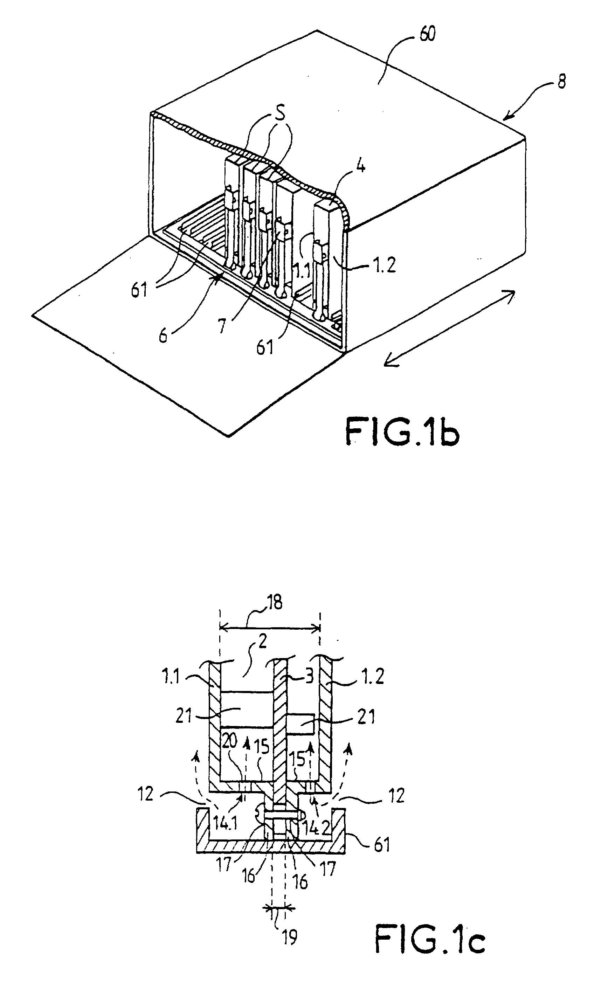

- la figure 1a une vue en éclaté d'une structure modulaire selon l'invention logeant une carte de circuit imprimé,
- la figure 1b une baie à l'intérieur de laquelle se trouve plusieurs structures modulaires selon l'invention,
- la figure 1 c un détail de la structure modulaire de la figure 1a, glissée dans la baie,
- la figure 2 une vue en éclaté d'une structure modulaire selon l'invention logeant deux cartes de circuit imprimé,
- la figure 3 une vue en éclaté d'une structure modulaire selon l'invention logeant trois cartes de circuit imprimé.

La figure 1a montre en éclaté une structure modulaire S conforme à l'invention. Cette structure modulaire S a une forme sensiblement parallélipipédique, elle délimite un logement 2 pour au moins une carte de circuit imprimé 3. Elle comporte deux capots 1.1, 1.2 placés en vis-à-vis, destinés à coopérer l'un avec l'autre et entre lesquels prendra place la carte de circuit imprimé 3. Dans l'exemple décrit, les deux capots 1.1, 1.2 sont formés à partir de plaques sensiblement rectangulaires mais d'autre formes sont possibles et une seule carte de circuit imprimé est représentée. La carte de circuit imprimé 3 s'étend sensiblement parallèlement au plan principal des capots 1.1, 1.2.

Pour réaliser le logement 2 de la carte 3 de circuit imprimé, les deux capots 1.1, 1.2 coopèrent l'un avec l'autre en prenant en sandwich au niveau d'un premier bord 50 des moyens 5 de support d'un ou plusieurs blocs 10 de connexion pour la connexion et au niveau d'un second bord 40 des moyens 4 de support d'un mécanisme de verrouillage 7 pour maintenir la structure S en position connectée à l'installation électronique. Le second bord 40 est opposé au premier bord 50. Les moyens 5, 4 de support des blocs de connexion et du mécanisme de verrouillage possèdent des extrémités respectivement 53, 41 disjointes avant montage entre les deux capots 11, 12. Le mécanisme de verrouillage 7 est visible sur les figures 2 et 3 mais pas sur la figure 1a. Des perçages 17 peuvent être prévus à la fois sur les moyens de support 4, 5 et sur les bords 40, 50 pour permettre un assemblage par exemple par vissage des deux capots 1.1, 1.2.

Les moyens de support 5, 4 des blocs 10 de connexion et du mécanisme de verrouillage 7 servent à caler les capots l'un par rapport à l'autre. Les deux capots 1.1, 1.2 sont rapportés sur les moyens de support 4, 5 des blocs de connexion et du mécanisme de verrouillage. Ils sont fixés à ces moyens de support 4, 5.

Les moyens 5 de support des blocs de connexion 10 peuvent être réalisés par au moins un premier barreau et les moyens 4 de support du mécanisme de verrouillage par au moins un second barreau. Il est envisageable d'avoir recours à d'autres éléments que des barreaux, par exemple des blocs de connexion moulés en un seul élément peuvent être pris en sandwich entre les deux capots.

Sur la figure 1a, les seconds bords 40 des capots 1.1, 1.2 sont situés sur la face 6 antérieure de la structure modulaire S, ce qui correspond à sa face accessible et visible lorsqu'elle est engagée dans une baie 60 d'une installation électronique. Une telle baie 60, équipée de plusieurs structures modulaires S conformes à l'invention est représentée à la figure 1b. Le mécanisme de verrouillage 7 est destiné, en position verrouillée, à maintenir la structure modulaire S en pression permanente au fond de la baie 60 pour que les blocs de connexion 10 restent connectés à d'autres blocs de connexion 101 extérieurs à la structure et se présentant face à eux. En position déverrouillée il autorise l'extraction de la structure hors de la baie 60. On peut envisager que la structure modulaire S soit connectée à une installation électronique sans être glissée, à la manière d'un tiroir dans une baie, le mécanisme de verrouillage aurait toujours un rôle de maintien en position connectée.

Sur la figure 1a, les premiers bords 50 des capots 1.1, 1.2 sont situés sur la face 8 postérieure de la structure modulaire S, ce qui correspond à sa face qui se trouve au fond de la baie 60. Le premier barreau 5 est configuré pour contribuer à délimiter, lorsqu'il est pris en sandwich entre les deux capots 1.1, 1.2 au moins une ou plusieurs alvéoles 9 ouvertes vers l'extérieur du logement 2, destinées à recevoir chacune un bloc de connexion 10, schématisé sur la figure 1a par un simple parallélépipède rectangle. La carte de circuit imprimé 3 sera reliée à ce bloc de connexion 10. La liaison à la carte de circuit imprimé 3 peut se faire par des pattes 28 qu'elles soient de report pour un montage en surface ou à piquer dans le circuit. Des pattes 28 de repport pour un montage en surface sont visibles sur la figure 2.

Sur la figure 1a, le premier barreau 5 contribue à délimiter trois alvéoles 9 juxtaposées. Il comporte un montant 51 qui suit le premier bord 50 de chacun des capots 1.1, 1.2 et sur lequel sont fixées quatre 52 barres transversales. Ce montant 51 réalise le fond des alvéoles 9, tandis que deux barres 52 successives et les deux capots 1.1, 1.2 réalisent les parois latérales d'une alvéole 9. Le fond des alvéoles 9 laisse un passage 29 pour réaliser la liaison entre la carte de circuit imprimé 3 et les blocs de connexion 10.

Les blocs de connexion 10 qui viendront se loger dans les alvéoles 9 comportent de manière classique une pluralité d'éléments de connexion (non représentés) axés parallèlement à la direction d'enfoncement de la structure modulaire S dans la baie 60, cette direction étant représentée par une flèche sur la figure 1b.

Selon une autre caractéristique de l'invention, les capots 1.1, 1.2 intègrent chacun, au niveau d'au moins un autre bord 11, 12 des moyens de rigidification 14.1, 14.2, ces moyens de rigidification permettent d'améliorer la coopération des capots 1.1, 1.2 entre eux. Ces moyens de rigidification 14.1, 14.2 peuvent être matérialisés par au moins une portion réalisant au moins un changement de direction par rapport à la surface principale du capot 1.1. Sur les figures, le capot 1.1 présente une cornière 14.1 sur chacun de ses bords 11, 12 et le capot 1.2 une cornière 14.2 sur chacun de ses bords 11, 12. Ces deux bords 11, 12 sont opposés. La longueur L des cornières 14.1, 14.2 est au maximum égale à l'intervalle séparant les moyens de support des blocs de connexion et du mécanisme de verrouillage lorsqu'ils sont pris en sandwich entre les deux capots 1.1, 1.2.

Les cornières 14.1, 14.2 comportent deux ailes 15, 16 qui réalisent deux changements de direction par rapport à la surface principale du capot 1.1, 1.2 qui la porte. Dans l'exemple décrit, la première aile 15 médiane est sensiblement perpendiculaire à cette surface et la seconde aile 16 extrême est sensiblement parallèle.

La solidarisation des deux capots 1.1, 1.2 en vis-à-vis se fait notamment au niveau de leurs secondes ailes 16 extrêmes, à cet effet, elles sont dotées de perçages 17 permettant d'utiliser des vis pour les rendre solidaires. Au moins un des capots 1.1 porte une carte de circuit imprimé 3, elle peut être fixée aux moyens de rigidification 14.1, 14.2, par exemple aux ailes 16 extrêmes.

Les deux capots 1.1, 1.2 composant la structure modulaire S peuvent ne pas être identiques. On peut à cet effet se référer à la figure 1c qui montre une coupe transversale partielle d'un exemple de structure modulaire S selon l'invention, au niveau des bords inférieurs 12 des capots 1.1, 1.2. Les moyens de rigidification 14.1 de l'un 1.1 des capots ne sont pas identiques aux moyens de rigidification 14.2 de l'autre. Les ailes médianes 15 des cornières 14.1 d'un capot 1.1 n'ont pas la même largeur que les ailes médianes 15 des cornières 14.2 de l'autre capot 1.2. Le logement 2 est asymétrique par rapport au plan de la carte de circuit imprimé 3 qu'il contient. Cette asymétrie permet de loger des cartes de circuits imprimés 3 portant sur l'une de leurs faces des composants électroniques 21 plus hauts que ceux portés par l'autre face, sans conduire à une structure modulaire S trop volumineuse.

Les capots 1.1, 1.2 peuvent jouer un rôle de dissipateur thermique pour un refroidissement par conduction. Les composants électroniques 21 dissipant de la chaleur peuvent être en contact thermique direct ou indirect avec les capots 1.1, 1.2. Un contact thermique direct est aménagé entre le composant 21 et le capot 1.1 sur la figure 1c. Les capots 1.1, 1.2 pourront être réalisés dans un matériau conduisant la chaleur tel que, par exemple, le cuivre, l'aluminium.

Lorsque les deux capots 1.1, 1.2 coopèrent l'un avec l'autre, l'intervalle 18 qui les séparent au niveau du logement 2 est plus grand que celui 19 qui sépare les ailes extrêmes 16 de leurs cornières 14.1, 14.2 en vis-à-vis.

Sur cette figure 1c, on suppose que la structure modulaire S est logée dans une baie telle que celle de la figure 1b et que les cornières 14.1, 14.2 de chacun des capots 1.1, 1.2 venant en vis à vis se retrouvent dans une même glissière 61 de la baie . Ici il s'agit d'une glissière inférieure mais on retrouverait le même agencement au niveau d'une glissière supérieure. La largeur de la glissière 61 est sensiblement celle du sandwich formé par les capots 1.1, 1.2 et les moyens de support 5 des blocs de connexion et les moyens de support 4 du mécanisme de verrouillage. C'est au niveau de ces moyens de support 4, 5 que s'effectuera le maintien de la structure modulaire S dans la glissière 61. Dans la configuration avec barreaux 4, 5 on voit que la tranche des barreaux 4, 5 vient en contact avec le fond de la glissière 61. Sur la figure 1b, la baie 60 est découpée pour laisser apparaître la tranche supérieure des premiers barreaux 4 mais les glissières supérieures ne sont pas représentées pour ne pas surcharger la figure.

Sur la figure 1c, les barreaux ne sont pas visibles car la coupe a été réalisée dans une zone médiane de la structure modulaire S. A cet endroit, les deux ailes extrêmes 16 sont en contact avec la glissière 61 mais elles n'occupent pas tout son volume intérieur.

Dans certaines applications, on cherche à ventiler efficacement l'intérieur du logement 2 et on dote les ailes 15 médianes d'ouvertures 20. Lors de la ventilation de la baie par un fluide forcé injecté au niveau de la glissière 61, celui-ci pénètre dans le logement 2 par les ouverture 20 pour aller refroidir les composants électroniques qui s'y trouvent et lèche aussi l'extérieur de la structure modulaire S. Des flèches en pointillés simulent le trajet du fluide. Une ventilation à la fois interne et externe est alors possible et efficace. Cette ventilation à la fois interne et externe peut s'ajouter au refroidissement par conduction.

Dans l'art antérieur avec cadre, toute une traverse du cadre était située dans la glissière en occupant tout le volume intérieur de celle-ci et la ventilation externe était quasi inexistante. Un blocage de la circulation du fluide apparaissait au niveau de la traverse du cadre.

Dans d'autres applications particulières, il peut être recommandé de ne pas ventiler directement les composants 21 mais seulement les capots 1.1, 1.2 ce qui s'obtient en omettant les ouvertures 20 sur les ailes médianes 15.

II est préférable pour améliorer le maintien et le raidissement de la carte 3 de circuit imprimé de prévoir au moins une barre de raidissement 22 fixée sur la carte de circuit imprimé 3. Cette barre de raidissement 22 peut aussi être solidaire d'un des capots 1.1, 1.2, ce qui améliore encore les performances en cas de vibrations, de chocs, d'accélérations brusques.

Sur la figure 1a, deux barres de raidissement 22 sont dessinées. Elles sont disposées chacune sur une face de la carte de circuit imprimé 3. En prévoyant deux barres de raidissement 22, chacune sur une face de la carte de circuit imprimé 3, cette dernière est bien maintenue dans le logement 2, elle est aussi fixée aux deux capots 1.1, 1.2. La structure modulaire S peut alors être utilisée de manière fiable dans un environnement sévère sujet aux vibrations, aux accélérations brusques, aux chocs etc... Lorsqu'il y a plusieurs barres de raidissement 22, il n'est pas nécessaire qu'elles aient la même longueur. Il est préférable qu'elles soient dirigées sensiblement selon la même direction.

De par sa conception, la structure modulaire S conforme à l'invention est à composition variable. Tandis que la figure 1a présente une structure modulaire S avec une seule carte de circuit imprimé 3, la structure de la figure 2 en comporte deux 3.1, 3.2 et celle de la figure 3 en comporte trois 3.1, 3.2, 3.3. Ces chiffres ne sont pas limitatifs.

Sur la figure 2, on retrouve les deux capots 1.1, 1.2 similaires à ceux de la figure 1a. Chacun d'entre 1.1, 1.2 eux porte une carte de circuit imprimé 3.1, 3.2. Les deux capots 1.1, 1.2 coopèrent en prenant en sandwich au niveau d'un premier bord 50 deux premiers barreaux 5 juxtaposés et au niveau d'un second bord 40 deux seconds barreaux 4 juxtaposés. Dans cette figuration particulière, le mécanisme de verrouillage 7 est porté à la fois par les deux seconds barreaux 4 mais d'autres configurations sont possibles. Les premiers barreaux 5 sont similaires à ceux décrits aux figures 1.

Le fait d'utiliser plusieurs premiers et seconds barreaux 5, 4 juxtaposés permet de simplifier le montage des structures modulaires S conformes à l'invention en réduisant le nombre de pièces différentes à approvisionner. Les structures modulaires des figures 2 et 3 comportent autant de premiers barreaux 5 et de seconds barreaux 4 que de cartes de circuit imprimé 3.1, 3.2, 3.3.

Il aurait bien sûr été possible de n'utiliser qu'un seul premier barreau et qu'un seul second barreau d'épaisseur appropriée pour que le logement 2 puisse accueillir le nombre de cartes de circuit imprimé voulu.

Dans les variantes avec plusieurs cartes de circuit imprimé 3, les capots 1.1, 1.2 sont solidaires l'un de l'autre par l'intermédiaire d'au moins un espaceur 23 pris en sandwich entre les moyens de rigidification 4.1 de l'un 1.1 et les moyens de rigidification 14.2 de l'autre 1.2.

La longueur de cet espaceur 23 est sensiblement celle des moyens de rigidification 14.1, 14.2. Plus précisément, sur l'exemple de la figure 2, à deux cartes de circuit imprimé 3.1, 3.2, l'espaceur 23 est fixé d'un côté à l'un des capots 1.1 et de l'autre à l'autre 1.2 au niveau des ailes 16 extrêmes de leurs cornières 14.1, 14.2 en vis à vis. Sur la figure 3 avec trois cartes de circuit imprimé 3.1, 3.2, 3.3 et deux espaceurs 23.1, 23.2, l'une des cartes 3.2 est fixée à l'espaceur 23.2 et chacun des capots 1.1, 1.2 porte une carte de circuit imprimé respectivement 3.1, 3.3.

Pour conserver une bonne ventilation de l'intérieur du logement 2, l'espaceur 23 est pourvu d'au moins une ouverture 20 de ventilation. Mais il est bien sûr envisageable de supprimer ces ouvertures de ventilation si une ventilation interne n'est pas recommandée. Dans la variante de la figure 3 avec trois cartes de circuit imprimé 3.1, 3.2, 3.3 on a représenté deux espaceurs juxtaposés 23.1, 23.2 qui peuvent avoir des épaisseurs différentes si les composants électroniques des cartes le requièrent.

Les figures 2 et 3 montrent des structures modulaires S vues par leur face postérieure 8. Les premiers barreaux 5 sont vus de face et ils sont équipés de moyens de détrompage 24 représentés sous forme d'orifices dirigés vers l'extérieur du logement 2 aptes à s'engager chacun dans un pion (non représenté) porté par la baie 60. Les orifices sont situés aux deux extrémités des premiers barreaux 5. Ces orifices ont un contour, généralement à pans coupés, interdisant toute possibilité de verrouillage de la structure modulaire dans la baie à une place qui ne lui est pas affectée. D'autres moyens de détrompage sont bien sûr envisageables sans sortir du cadre de l'invention. Des moyens de positionnement 25 de la structure S modulaire dans la baie sont aussi représentés sur les premiers barreaux 5. Ils sont aussi représentés sous forme d'orifices dans lesquels viennent se loger des ergots (non représentés) portés par la baie . D'autres moyens de positionnement 25 sont bien sûr envisageables sans sortir du cadre de l'invention.

## Revendications

1. Structure modulaire (S) porte-carte de circuit imprimé (3), devant être connectée à une installation électronique, comportant deux capots (1.1, 1.2) en vis-à-vis, contribuant à délimiter un logement (2) pour au moins une carte de circuit imprimé (3), **caractérisée en ce que** les capots (1.1, 1.2) coopèrent l'un avec l'autre en prenant en sandwich au niveau d'un premier bord (50) des moyens de support (5) d'un ou plusieurs blocs de connexion (10) pour la connexion et au niveau d'un second bord (40) des moyens de support (4) d'un mécanisme de verrouillage (7) pour maintenir la structure (S) en position connectée, les moyens de support (4, 5) du mécanisme de verrouillage (7) et des blocs de connexion (10) possédant des extrémités (41, 53) disjointes avant le montage des capots (1.1, 1.2).

2. Structure modulaire (S) selon la revendication 1, **caractérisée en ce que** les capots (1.1, 1.2) intègrent sur au moins un autre bord (11, 12) des moyens de rigidification (14.1, 14.2) permettant de solidariser les capots (1.1, 1.2) l'un avec l'autre.

3. Structure modulaire (S) selon l'une des revendications 1 ou 2, **caractérisée en ce que** les moyens de support (4) du mécanisme de verrouillage (7) ont la forme d'au moins un barreau.

4. Structure modulaire (S) selon l'une des revendications 1 à 3, **caractérisée en ce que** les moyens de support (5) des blocs de connexion (10) ont la forme d'au moins un barreau agencé de manière à contribuer à délimiter, lorsqu'il est pris en sandwich, une ou plusieurs alvéoles (9) ouvertes vers l'extérieur du logement (2) pour recevoir les blocs de connexion (10).

5. Structure modulaire (S) selon la revendication 4, **caractérisée en ce qu'**un bloc de connexion (10) est destiné à être relié d'une part à la carte (3) de circuit imprimé et d'autre part à un autre bloc de connexion (101) extérieur à la structure (S) et se présentant face à lui.

6. Structure modulaire (S) selon l'une des revendications 1 à 5, **caractérisée en ce que** les moyens de rigidification ont la forme d'au moins une cornière (14.1, 14.2) comportant deux ailes, l'une médiane (15) et l'autre extrême (16), ces ailes réalisant deux changements de direction par rapport à la surface principale des capots.

7. Structure modulaire (S) selon la revendications 6, **caractérisée en ce que** les ailes extrêmes (16) sont pourvues de perçages (17) en vue de leur assemblage.

8. Structure modulaire (S) selon l'une des revendications 6 ou 7, **caractérisée en ce que** les ailes médianes (15) sont pourvues d'au moins une ouverture (20) de ventilation.

9. Structure modulaire (S) selon l'une des revendications 6 à 8, **caractérisée en ce que** l'aile médiane (15) d'une cornière (14.1) appartenant à l'un des capots (1.1) a une largeur différente de celle d'une cornière (14.2) appartenant à l'autre capot (1.2).

10. Structure modulaire (S) selon l'une des revendications 1 à 9, **caractérisée en ce qu'**au moins un des capots (1.1) porte une carte (3) de circuit imprimé, la solidarisation entre le capot (1.1) et la carte (3) se faisant au niveau d'une cornière (14.1).

11. Structure modulaire (S) selon l'une des revendications 1 à 10, **caractérisée en ce que** la carte de circuit imprimé (3) porte au moins une barre (22) de raidissement.

12. Structure modulaire (S) selon la revendication 11, **caractérisée en ce que** la barre de raidissement est solidaire d'un des capots (1.1, 1.2).

13. Structure modulaire (S) selon l'une des revendications 11 ou 12, **caractérisée en ce que** la carte de circuit imprimé (3) porte au moins une barre (22) de raidissement sur chacune de ses faces.

14. Structure modulaire (S) selon la revendication 13, **caractérisée en ce que** deux barres (22) de raidissement portées par deux faces différentes de la carte de circuit imprimé (3) ont des longueurs différentes.

15. Structure modulaire (S) selon l'une des revendications 13 ou 14, **caractérisée en ce que** deux barres (22) de raidissement portées par deux faces différentes de la carte de circuit imprimé (3) ont sensiblement la même orientation.

16. Structure modulaire (S) selon l'une des revendications 2 à 15, **caractérisée en ce que** les capots (1.1, 1.2) prennent en sandwich au moins un espaceur (23) entre les moyens de rigidification (14.1) de l'un (1.1) et les moyens de rigidification (14.2) de l'autre (1.2), lorsqu'elle loge plusieurs cartes de circuit imprimé (3.1, 3.2, 3.3).

17. Structure modulaire (S) selon la revendication 16, **caractérisée en ce que** l'espaceur (23) est pourvu d'au moins une ouverture (20) de ventilation.

18. Structure modulaire (S) selon l'une des revendications 16 ou 17, **caractérisée en ce qu'**une carte de circuit imprimé (3.2) est fixée à un espaceur (23.2) lorsque la structure modulaire (S) loge plus de deux cartes de circuit imprimé.

19. Structure modulaire (S) selon l'une des revendications 1 à 18, **caractérisée en ce que** les moyens de support (5) des blocs de connexion (10) portent des moyens de détrompage (24).

20. Structure modulaire (S) selon l'une des revendications 1 à 19, **caractérisée en ce que** les moyens de support (5) des blocs de connexion (10) portent des moyens de positionnement (25) dans une baie (60) de l'installation électronique.

## Patentansprüche

1. Modulare Struktur (S) zur Aufnahme von Druckschaltungskarten (3), die an eine elektronische Anlage angeschlossen werden sollen, mit zwei einander gegenüberliegenden Hauben (1.1, 1.2), die zur Begrenzung eines Raums (2) für mindestens eine Druckschaltungskarte (3) beitragen, **dadurch gekennzeichnet, daß** die Hauben (1.1, 1.2) zusammenwirken, indem sie in Höhe eines ersten Rands (50) Tragmittel für einen oder mehrere Anschlußblöcke (10) für den Anschluß und in Höhe eines zweiten Rands (40) Tragmittel (4) für einen Verriegelungsmechanismus (7) sandwichartig halten, um die Struktur (S) in der angeschlossenen Position zu halten, wobei die Tragmittel (4, 5) für den Verriegelungsmechanismus (7) und die Anschlußblöcke (10) Enden (41, 53) besitzen, die vor der Montage der Hauben (1.1, 1.2) voneinander getrennt sind.

2. Modulare Struktur (S) nach Anspruch 1, **dadurch gekennzeichnet, daß** die Hauben (1.1, 1.2) an mindestens einem weiteren Rand (11, 12) Versteifungsmittel (14.1, 14.2) integrieren, mit denen die Hauben (1.1, 1.2) aneinander befestigt werden können.

3. Modulare Struktur (S) nach einem der Ansprüche 1 und 2, **dadurch gekennzeichnet, daß** die Tragmittel (4) für den Verriegelungsmechanismus (7) die Form mindestens eines Stabs aufweisen.

4. Modulare Struktur (S) nach einem der Ansprüche 1 bis 3, **dadurch gekennzeichnet, daß** die Tragmittel (5) für die Anschlußblöcke (10) die Form mindestens eines Stabs haben, der so ausgebildet ist, daß er einen oder mehrere nach außerhalb des Raums (2) offene Räume (9) zur Aufnahme der Anschlußblöcke (10) aufweist, wenn er sandwitchartig gehalten wird.

5. Modulare Struktur (S) nach Anspruch 4, **dadurch gekennzeichnet, daß** ein Anschlußblock (10) zum Anschluß einerseits an die Druckschaltungskarte (3) und andrerseits an einen Anschlußblock (101) bestimmt ist, der außerhalb der Struktur (S) diesem gegenüberliegt.

6. Modulare Struktur (S) nach einem der Ansprüche 1 bis 5, **dadurch gekennzeichnet, daß** die Versteifungsmittel die Form mindestens eines Winkelprofils (14.1, 14.2) mit zwei Schenkeln besitzen, nämlich einem mittleren Schenkel (15) und einem äußeren Schenkel (16), die zwei Richtungswechsel bezüglich der Hauptfläche der Hauben realisieren.

7. Modulare Struktur (S) nach Anspruch 6, **dadurch gekennzeichnet, daß** die äußeren Schenkel (16) mit Löchern (17) für ihren Zusammenbau versehen sind.

8. Modulare Struktur (S) nach einem der Ansprüche 6 und 7, **dadurch gekennzeichnet, daß** die mittleren Schenkel (15) mindestens eine Lüftungsöffnung (20) aufweisen.

9. Modulare Struktur (S) nach einem der Ansprüche 6 bis 8, **dadurch gekennzeichnet, daß** der mittlere Schenkel (15) eines Winkelprofils (14.1) einer der Hauben (1.1) eine andere Breite als ein Winkelprofil (14.2) der anderen Haube (1.2) besitzt.

10. Modulare Struktur (S) nach einem der Ansprüche 1 bis 9, **dadurch gekennzeichnet, daß** mindestens eine der Hauben (1.1) eine Druckschaltungskarte (3) trägt, wobei die Befestigung zwischen der Haube (1.1) und der Druckschaltungskarte (3) in Höhe eines Winkelprofils (14.1) erfolgt.

11. Modulare Struktur (S) nach einem der Ansprüche 1 bis 10, **dadurch gekennzeichnet, daß** die Druckschaltungskarte (3) mindestens eine Versteifungsleiste (22) enthält.

12. Modulare Struktur (S)nach Anspruch 11, **dadurch gekennzeichnet, daß** die Versteifungsleiste mit einer der Hauben (1.1, 1.2) fest verbunden ist.

13. Modulare Struktur (S) nach einem der Ansprüche 11 und 12, **dadurch gekennzeichnet, daß** die Druckschaltungskarte (3) mindestens eine Versteifungsleiste (22) auf jeder ihrer Seiten trägt.

14. Modulare Struktur (S) nach Anspruch 13, **dadurch gekennzeichnet, daß** zwei Versteifungsleisten (22), die auf zwei unterschiedlichen Seiten der Druckschaltungskarte (3) liegen, unterschiedliche Längen besitzen.

15. Modulare Struktur (S) nach einem der Ansprüche 13 und 14, **dadurch gekennzeichnet, daß** zwei Versteifungsleisten (22), die auf zwei unterschiedlichen Seiten der Druckschaltungskarte (3) liegen, im wesentlichen die gleiche Richtung besitzen.

16. Modulare Struktur (S) nach einem der Ansprüche 2 bis 15, **dadurch gekennzeichnet, daß** die Hauben (1.1, 1.2) mindestens einen Abstandshalter (23) zwischen den Versteifungsmitteln (14.1, 14.2) der einen Haube (1.1) und den Versteifungsmitteln (14.2) der anderen Haube (1.2) sandwichartig einschließen, wenn die Struktur mehrere Druckschaltungskarten (3.1, 3.2, 3.3) enthält.

17. Modulare Struktur (S) nach Anspruch 16, **dadurch gekennzeichnet, daß** der Abstandshalter (23) mit mindestens einer Lüftungsöffnung (20) versehen ist.

18. Modulare Struktur (S) nach einem der Ansprüche 16 und 17, **dadurch gekennzeichnet, daß** eine Druckschaltungskarte (3.2)an einem Abstandshalter (23.2) befestigt ist, wenn die modulare Struktur (S) mehr als zwei Druckschaltungskarten enthält.

19. Modulare Struktur (S) nach einem der Ansprüche 1 bis 18, **dadurch gekennzeichnet, daß** die Tragmittel (5) für die Anschlußblöcke (10) Schutzmittel (24) gegen falsches Einsetzen der Druckschaltungskarten besitzen.

20. Modulare Struktur (S) nach einem der Ansprüche 1 bis 19, **dadurch gekennzeichnet, daß** die Tragmittel (5) der Anschlußblöcke (10) Positioniermittel (25) zur Positionierung (25) in einem Gehäuse (60) der elektronischen Anlage enthalten.

## Claims

1. Modular structure (S) for carrying printed circuit boards (3), having to be connected to an electronic installation and comprising two cover plates (1.1, 1.2) opposite each other, contributing to defining a housing (2) for at least one printed circuit board (3), **characterized in that** the cover plates (1.1, 1.2) engage one with the other by sandwiching, via a first edge (50), support means (5) for one or more connection blocks (10) for the connection and, via a second edge (40), support means (4) for a locking mechanism (7) in order to hold the structure (S) in a connected position, the support means (4, 5) for the locking mechanism (7) and for the connection blocks (10) having ends (41, 53) which are separate before the assembly of the cover plates (1.1, 1.2).

2. Modular structure (S) according to Claim 1, **characterized in that** the cover plates (1.1, 1.2) include on at least one other edge (11, 12) stiffening means (14.1, 14.2) making it possible to secure the cover plates (1.1, 1.2) to each other.

3. Modular structure (S) according to either of Claims 1 or 2, **characterized in that** the support means (4) for the locking mechanism (7) have the form of at least one bar.

4. Modular structure (S) according to one of Claims 1 to 3, **characterized in that** the support means (5) for the connection blocks (10) have the form of at least one bar arranged so as to contribute to defining, when it is sandwiched, one or more cavities (9) open towards the outside of the housing (2) in order to receive the connection blocks (10).

5. Modular structure (S) according to Claim 4, **characterized in that** one connection block (10) is intended to be connected, on one side, to the printed circuit board (3) and, on the other side, to another connection block (101) external to the structure (S) and facing it.

6. Modular structure (S) according to one of Claims 1 to 5, **characterized in that** the stiffening means have the form of at least one angle bracket (14.1, 14.2) comprising two flanges, one a median flange (15) and the other an end flange (16), these flanges making two changes in direction relative to the main surface of the cover plate.

7. Modular structure (S) according to Claim 6, **characterized in that** the end flanges (16) are provided with holes (17) for the purpose of assembling them.

8. Modular structure (S) according to either of Claims 6 or 7, **characterized in that** the median flanges (15) are provided with at least one opening (20) for ventilation.

9. Modular structure (S) according to one of Claims 6 to 8, **characterized in that** the median flange (15) of an angle bracket (14.1) belonging to one of the cover plates (1.1) has a width different to that of an angle bracket (14.2) belonging to the other cover plate (1.2).

10. Modular structure (S) according to one of Claims 1 to 9, **characterized in that** at least one of the cover plates (1.1) carries a printed circuit board (3), the fastening between the cover plate (1.1) and the board (3) being made by an angle bracket (14.1).

11. Modular structure (S) according to one of Claims 1 to 10, **characterized in that** the printed circuit board (3) carries at least one stiffening rod (22).

12. Modular structure (S) according to Claim 11, **characterized in that** the stiffening rod is secured to one of the cover plates (1.1, 1.2).

13. Modular structure (S) according to either of Claims 11 and 12, **characterized in that** the printed circuit board (3) carries at least one stiffening rod (22) on each one of its faces.

14. Modular structure (S) according to Claim 13, **characterized in that** two stiffening rods (22) carried by two different faces of the printed circuit board (3) have different lengths.

15. Modular structure (S) according to one of Claims 13 and 14, **characterized in that** two stiffening rods (22) carried by two different faces of the printed circuit board (3) have approximately the same orientation.

16. Modular structure (S) according to one of Claims 2 to 15, **characterized in that** the cover plates (1.1, 1.2) sandwich at least one spacer (23) between the stiffening means (14.1) of one cover plate (1.1) and the stiffening means (14.2) of the other cover plate (1.2), when the structure houses several printed circuit boards (3.1, 3.2, 3.3).

17. Modular structure (S) according to Claim 16, **characterized in that** the spacer (23) is provided with at least one opening (20) for ventilation.

18. Modular structure (S) according to either of Claims 16 and 17, **characterized in that** a printed circuit board (3.2) is fixed to a spacer (23.2) when the modular structure (S) houses more than two printed circuit boards.

19. Modular structure (S) according to one of Claims 1 to 18, **characterized in that** the support means (5) for the connection blocks (10) carry polarization means (24).

20. Modular structure (S) according to one of Claims 1 to 19, **characterized in that** the support means (5) for the connection blocks (10) carry means (25) for positioning them in an electronic installation rack (60).
